# FASCICULE DE BREVET EUROPEEN

(11) **EP 2 494 567 B1**
(45) Date de publication et mention de la délivrance du brevet: **25.02.2015**
(21) Numéro de dépôt: 10768247.8
(22) Date de dépôt: 25.10.2010
(51) Int. Cl.: H01H 9/52, F21V 29/00, F28D 15/02, H01L 23/427, H05K 7/20

(54) **DISPOSITIF DE REFROIDISSEMENT D'UN APPAREIL MOYENNE TENSION UTILISANT DES CALODUCS ISOLES**
VORRICHTUNG ZUR KÜHLUNG EINER MITTELSPANNUNGSVORRICHTUNG MIT ISOLIERTEN HEIZROHREN
DEVICE FOR COOLING A MEDIUM-VOLTAGE APPARATUS USING INSULATED HEAT PIPES

(30) Priorité: 26.10.2009 FR 0957482
(43) Date de publication de la demande: 05.09.2012
(73) Titulaire: Alstom Technology Ltd., 5400 Baden (CH)
(72) Inventeur: FRIGIERE, Denis, F-69150 DECINES (FR); RODRIGUES, Didier, F-38200 SERPAIZE (FR); WILLIEME, Jean-Marc, F-69350 LA MULATIERE (FR)
(74) Mandataire: Ilgart, Jean-Christophe
(86) Numéro de dépôt international: PCT/EP2010/066011
(87) Numéro de publication internationale: WO 2011/051196

(56) Documents cités:
- EP-A1- 1 657 731
- DE-A1- 3 941 388
- US-A- 3 662 137

## Description

### Domaine de l'invention et définition

L'invention concerne le domaine des disjoncteurs ou des sectionneurs de générateurs moyenne tension, placés dans une gaine de protection et utilisant des « caloducs » qui sont des dispositifs de refroidissement fonctionnant avec un fluide caloporteur à changement de phase.

On rappelle qu'un caloduc se présente sous la forme d'une enceinte allongée hermétique renfermant un fluide en équilibre avec sa phase gazeuse et sa phase liquide, en l'absence de tout autre gaz, sauf sous forme de traces.

### Définition

Caloduc : Appareil thermique se présentant sous la forme d'une enceinte allongée hermétique renfermant un fluide en équilibre avec sa phase gazeuse et sa phase liquide. La chaleur est transférée de la partie chaude à la partie froide du tube par vaporisation de la phase liquide et condensation de la vapeur dans la partie froide.

### Art antérieur et problème posé

Le souci permanent des constructeurs de ce type de matériel est d'augmenter la capacité de ces appareils à passer des courants d'ampérage de plus en plus importants, notamment au niveau des disjoncteurs et sectionneurs placés à l'intérieur de jeux de barres à la sortie de centrales productrices ou de distribution de courant électrique. C'est notamment le cas des disjoncteurs d'alternateurs.

Une méthode, généralement utilisée, consiste à homogénéiser la température de l'air en contact avec les différentes parties chauffantes et chauffées du disjoncteur concerné. Le refroidissement à l'intérieur d'une telle gaine de protection peut se faire par convexion naturelle ou forcée de l'air enfermé dans celle-ci et dans laquelle se trouve le disjoncteur, la température régnant à l'intérieur de celle-ci étant notablement supérieure à la température régnant à l'extérieur, c'est-à-dire de 30°C à au moins 40°C.

Une autre solution consiste à prévoir une augmentation de la section de passage du courant dans les différents éléments de transmission, donc de passer par une augmentation de la taille des pièces des disjoncteurs.

D'autre part, par le document de brevet EP 1 657 731, on connaît un dispositif et un procédé de refroidissement d'un disjoncteur ou d'un sectionneur moyenne tension. La figure 1 montre, en coupe, une réalisation décrite dans ce document. Elle représente principalement un conducteur moyenne tension 2 ou le carter d'un disjoncteur. Celui-ci est entouré d'évaporateurs 3 faisant partie d'un ensemble de refroidissement 1 de celui-ci. Un tel ensemble se complète d'un manchon d'isolation 7 entourant un caloduc 5 pour évacuer la chaleur collectée par les évaporateurs 3. Un manchon élastique 9 complète l'ensemble. Le tout est placé l'intérieur d'une gaine de protection 8. L'ensemble de refroidissement débouche sur le toit de cette gaine de protection 8 pour aboutir à un dispositif de condensation 4, par exemple à ailettes.

Le but de l'invention est de proposer une solution différente de ce type d'installation.

Le document US 3 662 137 A décrit un dispositif de refroidissement selon le préambule de la revendication 1.

### Résumé de l'invention

A cet effet, l'objet principal de l'invention est un dispositif de refroidissement à fluides caloporteurs à changement de phase pour un appareil électrique fonctionnant à moyenne tension et comprenant au moins un caloduc.

Selon l'invention, ce ou ces caloduc(s) est ou sont placé (s) de manière à pénétrer en partie dans l'appareil et est ou sont isolé(s) électriquement, dans cette partie encastrée, par un manchon isolant électriquement et bon conducteur de la chaleur.

Dans une première réalisation envisagée, le manchon est en nitrure d'aluminium fritté.

Dans une deuxième réalisation selon l'invention, le manchon est en nitrure de bore fritté.

De manière préférentielle, la partie externe du ou des caloduc(s) ne pénétrant pas dans l'appareil et aboutissant à un condenseur est munie également d'un manchon isolant électriquement.

Chaque caloduc peut posséder une bague isolante électriquement placée sur une partie externe du manchon isolant électriquement.

De même, chaque caloduc peut posséder, sur sa partie externe, un manchon isolant électriquement.

### Liste des figures

L'invention et ses différentes caractéristiques techniques seront mieux comprises à la lecture de la description suivante de trois réalisations de l'invention. Elle est accompagnée de six figures représentant respectivement :
- figure 1, un dispositif de refroidissement selon l'art antérieur ;
- figure 2, en coupe partielle, la technologie utilisée dans le dispositif selon l'invention ;
- figures 3A, 3B et 3C, en coupe transversale, trois réalisations de l'invention ; et
- figure 4, en coupe longitudinale, le dispositif selon l'invention, notamment celui de la figure 3C.

### Description détaillée de trois réalisations de l'invention

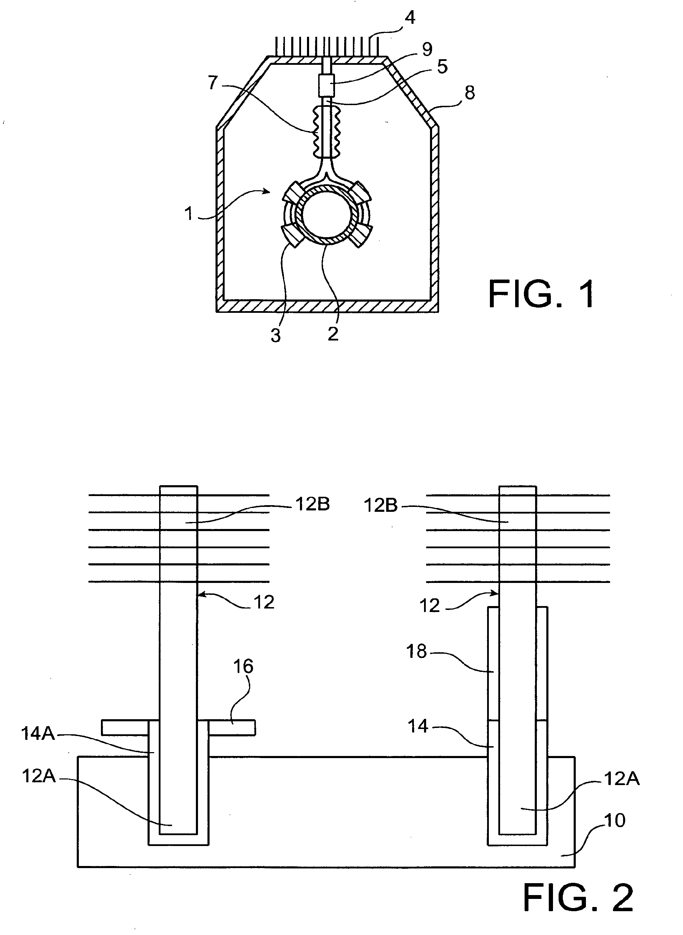

En référence à la figure 1, une partie du carter 10 d'un disjoncteur est représentée, mais possède une certaine épaisseur dans laquelle s'emmagasine la chaleur due au passage des courants électriques de moyenne tension et à fort ampérage.

Sur cette figure 2, deux caloducs sont représentés en pénétrant en partie dans le carter 10 du disjoncteur.

Sur la figure 2, la partie encastrée 12A du caloduc dans le carter 10 du disjoncteur est donc chauffée. Le fluide se trouvant dans ce caloduc 12 se vaporise en emmagasinant de l'énergie. Ce gaz se diffuse alors à l'intérieur du caloduc 12 jusqu'à l'autre extrémité non encastrée 12B, où il se condense. L'extrémité encastrée 12A est entourée d'un manchon isolant électriquement par rapport au carter 10 de disjoncteur, mais également bon conducteur thermique. On peut citer, en particulier, l'utilisation du nitrure d'aluminium fritté et l'utilisation du nitrure de bore fritté pour constituer ces manchons isolants électriquement 14.

L'ensemble peut se compléter, comme le montre le caloduc 12 de gauche, d'une bague en matériau isolant électriquement, entourant la partie externe 14A du manchon isolant électriquement pour augmenter la ligne de fuite.

Comme le montre le caloduc 12 de droite, la partie externe 12B peut également posséder un deuxième manchon isolant électriquement 18 pour augmenter la ligne de fuite.

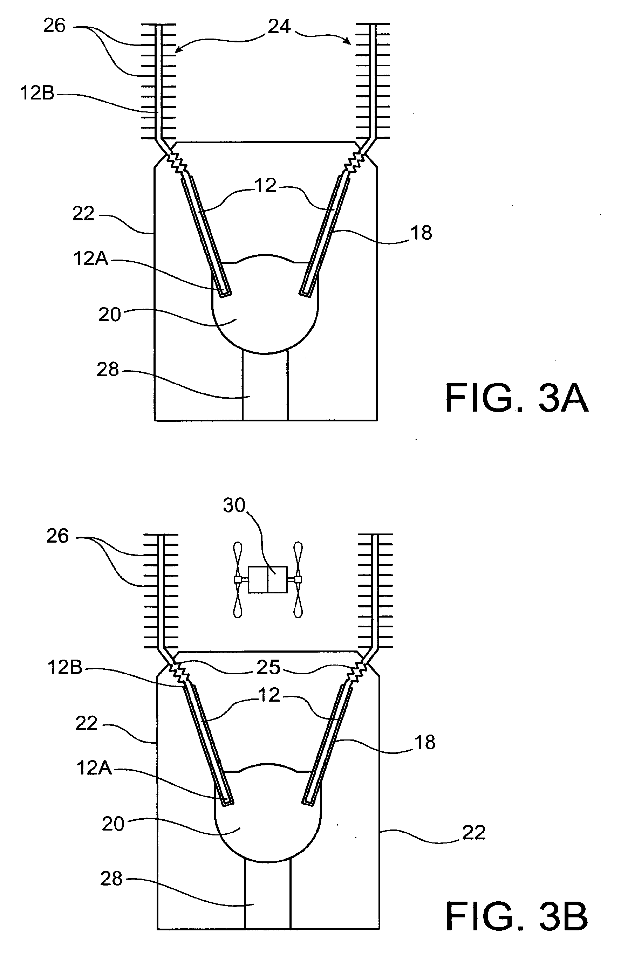

En référence à la figure 3A, une première implantation d'un tel principe dans un disjoncteur 20 est représentée. On y utilise, dans un même plan vertical, deux caloducs 12 pénétrant tous les deux par leur partie encastrée 12A dans le carter du disjoncteur 20. L'extrémité de la partie externe 12B de ces caloducs 12 est entourée d'un système d'ailettes 26 pour former un condenseur 24 afin de permettre la dissipation de la chaleur à l'extérieur d'une enceinte 22 dans laquelle est placé le disjoncteur 20.

Le retour du liquide se fait généralement par gravité, ce qui conduit à disposer le condenseur 24 en partie haute. Si l'intérieur du caloduc 12 est muni de canaux, le retour du liquide est accéléré par les forces de capillarité, ce qui permet également, en acceptant une perte d'efficacité, de disposer le condenseur 24 plus bas.

Sur cette figure 3A, en coupe verticale, on constate que le disjoncteur peut être placé sur un support isolant 28. De plus, les condenseurs 24 sont donc placés sur le toit de l'enceinte 22.

Les deux caloducs 12, représentés sur cette figure 3A, sont implantés dans le disjoncteur 20, de façon légèrement latérale, chacun d'un côté, de manière à ce que leur extrémité externe s'éloigne l'une de l'autre. Ainsi, ils peuvent atteindre des condenseurs 24, placés sur l'enceinte 22 de manière relativement écartée.

La figure 3B représente une réalisation qui reprend les éléments de la réalisation représentée par la figure 3A. Par contre, un dispositif de ventilation 30 est prévu au-dessus de l'enceinte 22 pour favoriser la circulation de l'air dans les condenseurs 24 et plus précisément entre les ailettes 26 de ces derniers.

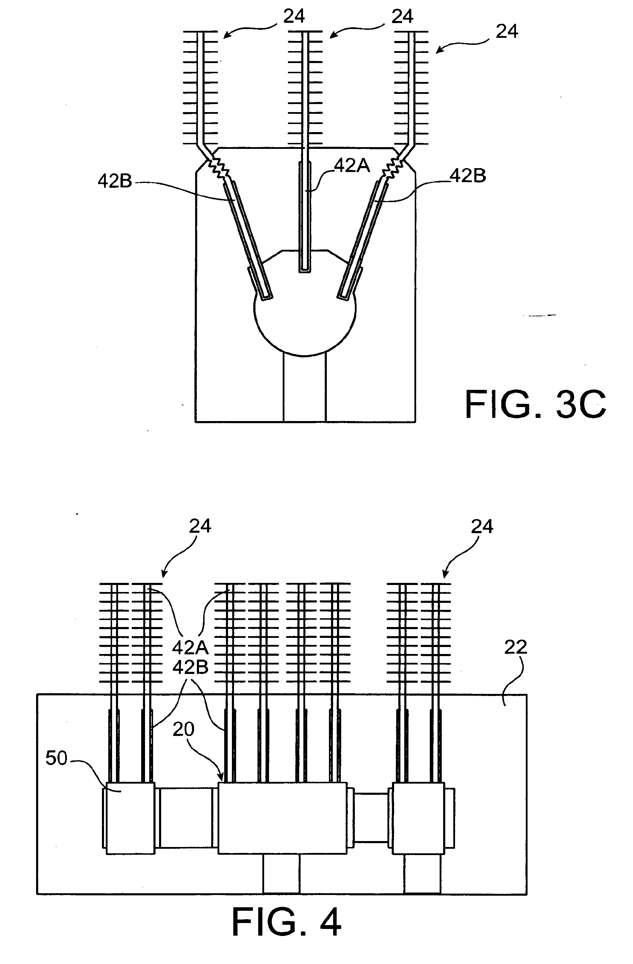

La figure 3C montre une troisième réalisation qui utilise un troisième caloduc 42A, placé entre les deux caloducs latéraux 42B.

Dans cette réalisation de la figure 3C, chaque caloduc 42A et 42B aboutit chacun à au moins un condenseur 24.

La figure 4 montre en coupe longitudinale la manière dont les caloducs 42A et 42B peuvent être implantés dans différents endroits d'un disjoncteur 20, voire dans d'autres appareils électriques 50 associés aux disjoncteurs 20 toujours placés à l'intérieur de l'enceinte 22, comme des sectionneurs de barre par exemple. Chaque caloduc 42A à 42B est toujours relié à un condenseur 24 placé sur le toit de l'enceinte 22.

L'adjonction de matériaux adaptés sur les parois internes des caloducs 12, 42A et 42B peut permettre de les implanter également la tête en bas, ce qui multiplie les possibilités de refroidissement.

Le principal avantage d'un tel dispositif est qu'il s'adapte à des technologies de caloducs et différents éléments de refroidissement déjà éprouvées, sans avoir le besoin de développer des procédés d'isolation devant contenir le liquide de refroidissement.

## Revendications

1. Dispositif de refroidissement à fluide caloporteur à changement de phase d'un appareil électrique à moyenne tension, comprenant :
- au moins un caloduc (12, 42A, 42B), **caractérisé en ce que** le au moins un caloduc (12, 42A, 42B) pénètre en partie dans l'appareil et est isolé électriquement dans cette partie encastrée (12A) par un manchon isolant électriquement (14) et bon conducteur de la chaleur.

2. Dispositif selon la revendication 1, **caractérisé en ce que** le manchon isolant électriquement (14) est en nitrure d'aluminium fritté.

3. Dispositif selon la revendication 1, **caractérisé en ce que** le manchon isolant électriquement (12, 42A, 42B) est en nitrure de bore fritté.

4. Dispositif selon la revendication 1, l'ensemble étant placé dans une gaine (22), **caractérisé en ce que** la partie externe (12B) des caloducs (12, 42A, 42B) ne pénétrant pas dans l'appareil aboutissant à des condenseurs (24) possède un manchon isolant électriquement (18).

5. Dispositif selon la revendication 1, **caractérisé en ce que** chaque caloduc (12) possède une bague isolante électriquement (16) placée sur une partie externe (14A) du manchon isolant électriquement (14).

6. Dispositif selon la revendication 1, **caractérisé en ce que** chaque caloduc (12, 42A, 42B) possède sur sa partie externe un manchon isolant électriquement (18).

## Patentansprüche

1. Kühlvorrichtung mit einer Wärmeträgerflüssigkeit mit Phasenwechsel zum Kühlen einer elektrischen Mittelspannungseinrichtung, enthaltend:
- zumindest ein Wärmerohr (12, 42A, 42B),
**dadurch gekennzeichnet, dass** das zumindest eine Wärmerohr (12, 42A, 42B) teilweise in die Einrichtung eingreift und in diesem eingebetteten Abschnitt (12A) über eine elektrisch isolierende und gut wärmeleitende Isolierhülse (14) elektrisch isoliert ist.

2. Vorrichtung nach Anspruch 1, **dadurch gekennzeichnet, dass** die elektrisch isolierende Isolierhülse (14) aus gesintertem Aluminiumnitrid besteht.

3. Vorrichtung nach Anspruch 1, **dadurch gekennzeichnet, dass** die elektrisch isolierende Isolierhülse (12, 42A, 42B) aus gesintertem Bornitrid besteht.

4. Vorrichtung nach Anspruch 1, wobei die Einheit in einem Mantel (22) angeordnet ist, **dadurch gekennzeichnet, dass** der äußere Teil (12B) der Wärmerohre (12, 42A, 42B), der nicht in die Einrichtung eingreift und zu Kondensatoren (24) führt, eine elektrisch isolierende Isolierhülse (18) besitzt.

5. Vorrichtung nach Anspruch 1, **dadurch gekennzeichnet, dass** jedes Wärmerohr (12) einen elektrisch isolierenden Isolierring (16) besitzt, der an einem äußeren Teil (14A) der elektrisch isolierenden Isolierhülse (14) angeordnet ist.

6. Vorrichtung nach Anspruch 1, **dadurch gekennzeichnet, dass** jedes Wärmerohr (12, 42A, 42B) an seinem äußeren Teil eine elektrisch isolierende Isolierhülse (18) besitzt.

## Claims

1. A cooling device using a phase-change heat-transfer fluid for medium-voltage apparatus, comprising:
• at least one heat pipe (12, 42A, 42B);
the device being **characterized in that** the at least one heat pipe (12, 42A, 42B) penetrates in part into the apparatus and is electrically insulated in this embedded portion (12A) by means of a sleeve (14) that is both electrically insulating and a good conductor of heat.

2. A device according to claim 1, **characterized in that** the electrically insulating sleeve (14) is made of sintered aluminum nitride.

3. A device according to claim 1, **characterized in that** the electrically insulating sleeve (12, 42A, 42B) is made of sintered boron nitride.

4. A device according to claim 1, the assembly being placed inside a sheath (22), the device being **characterized in that** the outside portion (12B) of the heat pipes (12, 42A, 42B) not penetrating into the apparatus terminating at the condensers (24) possesses an electrically insulating sleeve (18).

5. A device according to claim 1, **characterized in that** each heat pipe (12) possesses an electrically insulating ring (16) placed on an outside portion (14A) of the electrically insulating sleeve (14).

6. A device according to claim 1, **characterized in that** each heat pipe (12, 42A, 42B) possesses an electrically insulating sleeve (18) on its outside portion.
